# EUROPÄISCHE PATENTSCHRIFT

(11) **EP 2 193 559 B1**
(45) Veröffentlichungstag und Bekanntmachung des Hinweises auf die Patenterteilung: **03.04.2019**
(21) Anmeldenummer: 08804751.9
(22) Anmeldetag: 25.09.2008
(51) Int. Cl.: H01L 51/50

(54) **STRAHLUNGSEMITTIERENDE VORRICHTUNG**
DEVICE EMITTING RADIATION
DISPOSITIF ÉMETTANT UN RAYONNEMENT

(30) Priorität: 25.09.2007 DE 102007045753; 03.12.2007 DE 102007058005
(43) Veröffentlichungstag der Anmeldung: 09.06.2010
(73) Patentinhaber: OSRAM OLED GmbH, 93049 Regensburg (DE)
(72) Erfinder: FEHRER, Michael, 93077 Bad Abbach (DE); HEUSER, Karsten, 91056 Erlangen (DE); HÖFLING, Egbert, 93049 Regensburg (DE); SCHLENKER, Tilman, 93152 Nittendorf (DE); INGLE, Andrew, 85391 Allershausen (DE); POPP, Michael, 80538 München (DE); KLEIN, Markus, 93105 Tegernheim (DE); RIEGEL, Nina, 93105 Tegernheim (DE); SCHMID, Günter, 91334 Hemhofen (DE); KRAUSE, Ralf, 91058 Erlangen (DE); SEIDEL, Stefan, 93098 Mintraching (DE); KOZLOWSKI, Fryderyk, 91056 Erlangen (DE); HUNZE, Arvid, 91056 Erlangen (DE); GIERES, Günter, 91077 Kleinsendelbach (DE)
(74) Vertreter: Epping - Hermann - Fischer
(86) Internationale Anmeldenummer: PCT/EP2008/062864
(87) Internationale Veröffentlichungsnummer: WO 2009/040401

(56) Entgegenhaltungen:
- EP-A- 1 670 083
- WO-A-2006/078005
- WO-A-2006/130883
- JP-A- 2002 313 583
- JP-A- 2006 024 711
- US-A1- 2005 194 892

## Beschreibung

Die Erfindung betrifft eine strahlungsemittierende Vorrichtung mit zumindest einer ersten Emissionsschicht und einer zweiten Emissionsschicht.

Diese Patentanmeldung beansprucht die Priorität der deutschen Patentanmeldungen 10 2007 045 753.9 und 10 2007 058 005.5. Die Druckschrift WO 2006/078005 A1 beschreibt ein lichtemittierendes Bauteil, während die Druckschriften EP 1 670 083 A2, WO 2006/130883 A2, US 2005/0194892 A1 und JP 2002-313583 A jeweils auf ein organisches lichtemittierendes Bauteil und die Druckschrift JP 2006-024711 A auf ein organisches elektrolumineszentes Bauteil gerichtet ist. Aufgabe der Erfindung ist es, eine effiziente, langlebige strahlungsemittierende Vorrichtung bereitzustellen, deren Emissionsfarbe leicht einstellbar ist und nur geringe Variationen aufweist. Eine solche strahlungsemittierende Vorrichtung weist einen verbesserten Ladungstransport auf, der zur Verbesserung der Leistungseffizienz und der Lebensdauer beiträgt.

Diese Aufgabe wird durch eine strahlungsemittierende Vorrichtung gemäß dem Anspruch 1 gelöst. Weitere Ausführungsformen der Vorrichtung sind Gegenstand weiterer Ansprüche.

Eine strahlungsemittierende Vorrichtung umfasst eine erste Elektrode, die im Betrieb Ladungsträger einer ersten Ladung abgibt, eine erste Emissionsschicht, die ein erstes Emittermaterial aufweist und auf der ersten Elektrode angeordnet ist, eine zweite Emissionsschicht, die ein zweites Emittermaterial aufweist und auf der ersten Emissionsschicht angeordnet ist, sowie eine zweite Elektrode, die im Betrieb Ladungsträger einer zweiten Ladung abgibt und auf der zweiten Emissionsschicht angeordnet ist. Dabei ist das erste und/oder zweite Emittermaterial phosphoreszent und das erste Emittermaterial emittiert Strahlung bei einer anderen Wellenlänge als das zweite Emittermaterial. Eine solche strahlungsemittierende Vorrichtung weist eine effiziente Emission von Strahlung bei guter bis sehr guter Lebensdauer auf. Weiterhin ändert sich die Emissionsfarbe über die Lebensdauer hinweg nur wenig.

Die strahlungsemittierende Vorrichtung weist eine erste ladungstransportierende Schicht auf, die zwischen der ersten Emissionsschicht und der zweiten Emissionsschicht angeordnet ist. Die erste ladungstransportierende Schicht kann Ladungsträger der ersten Ladung und Ladungsträger der zweiten Ladung transportieren. Mit der ersten ladungstransportierenden Schicht kann der Ladungsträgertransport zwischen der ersten Emissionsschicht und der zweiten Emissionsschicht verbessert werden.

Die erste ladungstransportierende Schicht umfasst eine Matrix, die ein Matrixmaterial aufweist, das Ladungsträger der ersten und zweiten Ladung transportiert, oder ein erstes Matrixmaterial, das Ladungsträger der ersten Ladung transportiert, und ein zweites Matrixmaterial, das Ladungsträger der zweiten Ladung transportiert. Somit kann die Eigenschaft der ladungstransportierenden Schicht, Ladungsträger der ersten und der zweiten Ladung zu transportieren, erreicht werden. Dazu wird entweder ein einziges Matrixmaterial eingesetzt, das beide Ladungsträgerarten transportieren kann oder eine Mischung aus zwei Matrixmaterialien, die jeweils unterschiedliche Ladungsträgerarten transportieren können. Über das Mischungsverhältnis der Matrixmaterialien kann die Ladungsträgerbalance in der Vorrichtung und der Transport der Ladungsträger zu den einzelnen Emissionsschichten individuell angepasst werden. Weiterhin dient die ladungstransportierende Schicht dazu, die einzelnen Emissionsschichten voneinander zu trennen und damit Quenching und Energietransferprozesse zu unterdrücken. Durch die Dicke der ersten ladungstransportierenden Schicht kann weiterhin die Distanz der Emissionsschichten zu anderen Schichten eingestellt werden. Durch den ambipolaren Charakter der ersten ladungstransportierenden Schicht kann trotz der eventuell vergrößerten Schichtdicke bzw. der Gesamtdicke der Vorrichtung die Betriebsspannung gering gehalten werden und eine Akkumulation von Ladungsträgern an Grenzflächen zwischen den einzelnen Schichten minimiert werden. Damit verringert sich auch ein mögliches Quenching von Polaronen mit Exzitonen.

Die strahlungsemittierende Vorrichtung kann weiterhin eine dritte Emissionsschicht aufweisen, die ein drittes Emittermaterial aufweist und zwischen der zweiten Emissionsschicht und der zweiten Elektrode angeordnet ist. Dabei kann das dritte Emittermaterial bei einer anderen Wellenlänge Strahlung emittieren als das erste und zweite Emittermaterial. Durch die Verwendung von drei verschiedenen Emittermaterialien, die bei verschiedenen Wellenlängen Strahlung emittieren, kann eine Gesamtemission erzeugt werden, die sich aus den drei emittierten Strahlungen zusammensetzt und beispielsweise weißes Licht umfasst. Damit sind solche strahlungsemittierenden Vorrichtungen auch für Beleuchtungszwecke geeignet.

Weiterhin kann die dritte Emissionsschicht Ladungsträger der zweiten Ladung transportieren, die erste Emissionsschicht Ladungsträger der ersten Ladung transportieren und die zweite Emissionsschicht Ladungsträger der zweiten Ladung transportieren. Es können auch die erste und/oder zweite und/oder dritte Emissionsschicht Ladungsträger der ersten Ladung und Ladungsträger der zweiten Ladung transportieren. Dazu können die erste und/oder zweite und/oder dritte Emissionsschicht eine Matrix umfassen. Die Matrix kann ein Matrixmaterial aufweisen, das Ladungsträger der ersten und zweiten Ladung transportiert, oder sie kann ein erstes Matrixmaterial, das Ladungsträger der ersten Ladung transportiert, und ein zweites Matrixmaterial, das Ladungsträger der zweiten Ladung transportiert, aufweisen. Somit können sich die Emittermaterialien in unterschiedlichen Matrixmaterialien befinden, die übereinander angeordnet werden. Dadurch kann der Ladungsträgertransport in den Emissionsschichten durch die Schichten hindurch optimiert werden und ein Ladungsträgertransport über die Emittermaterialien vermieden werden, was zu einer Erhöhung der Lebensdauer führt. Durch den gezielten Einsatz einer Matrix aus erstem und zweitem Matrixmaterial, von denen jeweils ein Matrixmaterial einen Ladungsträgertyp bevorzugt transportiert, wird es ermöglicht, die Emittermaterialien in geringerer Konzentration einzusetzen und somit eine Triplett-Triplett-Annihilation zu minimieren. Würde nur ein Matrixmaterial eingesetzt werden bzw. nur ein Ladungsträgertyp bevorzugt transportiert werden, müsste der jeweils andere Ladungsträgertyp über die Grenzorbitale des Emittermaterials geführt werden, wodurch eine hohe Konzentration des Emittermaterials in der Matrix notwendig wäre. Das würde zu verringerter Emissionseffizienz des Emittermaterials und Quenching zwischen benachbarten Emittermolekülen führen. Die Konzentration der Matrixmaterialien wird so eingestellt, dass die Ladungsträger effizient zu den Emittermaterialien in den anderen Emissionsschichten weitergeleitet werden. Das einstellbare Mischungsverhältnis der Matrixmaterialien ermöglicht eine empfindliche Einstellung des Verhältnisses der Ladungsträgertypen und somit eine gute Abstimmbarkeit der Emissionsfarbe über einen weiten Bereich, ohne neue Materialien einsetzen zu müssen. Eine gleichmäßige Verteilung der beiden Ladungsträgertypen und des Emittermaterials über die gesamte Emissionsschicht führt weiterhin zu einer verbreiterten Rekombinationszone, womit eine höhere Effizienz und ein breiteres Emissionsspektrum einhergehen. Damit ist die strahlungsemittierende Vorrichtung besonders für Beleuchtungsanwendungen geeignet.

Die Vorrichtung kann weiterhin eine zweite ladungstransportierende Schicht aufweisen, die zwischen der zweiten und dritten Emissionsschicht angeordnet ist. Die zweite ladungstransportierende Schicht kann Ladungsträger der ersten Ladung und Ladungsträger der zweiten Ladung transportieren. Dabei umfasst die zweite ladungstransportierende Schicht eine Matrix. Die Matrix kann ein Matrixmaterial aufweisen, das Ladungsträger der ersten und zweiten Ladung transportiert, oder eine Mischung aus einem ersten Matrixmaterial, das Ladungsträger der ersten Ladung transportiert, und einem zweiten Matrixmaterial, das Ladungsträger der zweiten Ladung transportiert. Die zweite ladungstransportierende Schicht weist die gleichen Eigenschaften auf, wie sie oben für die erste ladungstransportierende Schicht genannt wurden, und trägt unter anderem dazu bei, dass auch die dritte Emissionsschicht von den anderen Emissionsschichten getrennt ist und einen geeigneten Abstand zu den übrigen Schichten hat.

Weiterhin kann die Vorrichtung eine erste Elektrode aufweisen, die reflektierend für die vom ersten und/oder zweiten Emittermaterial emittierte Strahlung ist. Die erste Elektrode kann auch reflektierend für die vom ersten und/oder zweiten und/oder dritten Emittermaterial emittierte Strahlung sein. Mit zunehmendem Abstand der Emissionsschichten zu der reflektierenden Elektrode können die jeweiligen Emittermaterialien Strahlung von größerer Wellenlänge emittieren. Beispielsweise kann sich eine blau emittierende Emissionsschicht am nächsten zur reflektierenden Elektrode befinden, eine rot emittierende Emissionsschicht am weitesten von der reflektierenden Elektrode entfernt. Damit wird die Radianz der einzelnen Farben in Vorwärtsrichtung erhöht, da eine negative Interferenz durch den einstellbaren Abstand der Emissionsschichten zu der reflektierenden Elektrode vermieden werden kann. Bei der ersten, reflektierenden Elektrode kann es sich um eine Kathode handeln.

Die zweite Elektrode kann transparent für die vom ersten und/oder zweiten Emittermaterial emittierte Strahlung sein. Sie kann weiterhin transparent für die vom ersten und/oder zweiten und/oder dritten Emittermaterial emittierte Strahlung sein. Die transparente Elektrode kann eine Anode umfassen. Die von der ersten, zweiten und dritten Emissionsschicht emittierte Strahlung kann somit durch die transparente Elektrode hindurch aus der strahlungsemittierenden Vorrichtung ausgekoppelt werden.

Die Ladungsträgerzufuhr kann durch weitere, zwischen der ersten und zweiten Elektrode vorhandenen Schichten unterstützt werden. Zwischen der ersten Elektrode und der ersten Emissionsschicht ist eine erste dotierte Transportschicht vorhanden, die die Ladungsträger der ersten Ladung transportiert. Dabei kann die erste Elektrode eine Kathode umfassen und die erste dotierte Transportschicht n-dotiert sein. In diesem Fall umfassen die Ladungsträger der ersten Ladung Elektronen und die erste dotierte Transportschicht eine Elektronentransportschicht. Damit können die von der Kathode erzeugten Elektronen besonders gut zu den Emissionsschichten transportiert werden. Zwischen der ersten dotierten Transportschicht und der ersten Emissionsschicht kann weiterhin eine erste Blockierschicht vorhanden sein, die Ladungsträger der zweiten Ladung blockiert und Ladungsträger der ersten Ladung transportiert. Somit können, wenn die erste Elektrode eine Kathode und die erste dotierte Transportschicht eine Elektronentransportschicht umfasst, die Elektronen zu den Emissionsschichten transportiert werden, während die Löcher an ihrem Transport gehindert werden.

Weiterhin kann zwischen der zweiten Elektrode und der der zweiten Elektrode am nächsten gelegenen Emissionsschicht eine zweite dotierte Transportschicht vorhanden sein, die Ladungsträger der zweiten Ladung transportiert. Es kann auch zwischen der zweiten dotierten Transportschicht und der der zweiten Elektrode am nächsten gelegenen Emissionsschicht eine zweite Blockierschicht vorhanden sein, die Ladungsträger der ersten Ladung blockiert und Ladungsträger der zweiten Ladung transportiert. Die zweite Elektrode kann eine Anode umfassen und die zweite dotierte Transportschicht kann p-dotiert sein. In diesem Fall können die Ladungsträger der zweiten Ladung Löcher und die zweite dotierte Transportschicht eine Lochtransportschicht umfassen. Somit können die von der Anode abgegebenen Löcher besonders gut zu den Emissionsschichten geleitet werden, während der Transport der Elektronen blockiert wird. Der Serienwiderstand dieser ersten und zweiten dotierten Transportschicht ist nahezu unabhängig von ihrer Schichtdicke. Somit lässt sich die Schichtdicke, und damit der Abstand der Emissionsschichten von den Elektroden einstellen und optimieren, ohne die elektrischen Eigenschaften des Bauteils zu verändern.

Die erste und/oder zweite und/oder dritte Emissionsschicht kann jeweils einen mittleren Abstand zu der reflektierenden Elektrode aufweisen, der einem Viertel der Wellenlänge der Emission der jeweiligen Emissionsschicht entspricht. Es sind aber auch Abweichungen von diesem Wert des mittleren Abstands möglich. Damit weist die strahlungsemittierende Vorrichtung eine kavitativ optimierte Schichtenfolge auf, da die Radianz der einzelnen Farben in Vorwärtsrichtung erhöht ist. Durch die einstellbaren Schichtdicken der ladungstransportierenden Schichten haben die Emissionsschichten einen verbesserten Abstand zu der reflektierenden Elektrode, sodass negative Interferenz vermieden werden kann.

Weiterhin können die den Emissionsschichten zugewandten Oberflächen der ersten und/oder zweiten Elektrode Unebenheiten einer bestimmten Höhe aufweisen. Solche Unebenheiten können trotz Substratreinigung auf diesen Oberflächen zurückgeblieben sein. Solche Unebenheiten können Partikel mit einer Dicke von weniger als 100 nm aufweisen, die mit üblichen Reinigungsschritten nicht entfernt werden können. Die Partikel können auch eine Dicke von mehreren µm aufweisen und stellen somit auf der ersten oder zweiten Elektrode massive Unebenheiten dar. Weiterhin können die Materialien, aus denen die erste und/oder zweite Elektrode hergestellt werden, dazu neigen, bei ihrer Abscheidung Spitzen auszubilden, die ebenfalls Unebenheiten bilden. Diese Spitzen können Höhen von über 10 nm aufweisen. Solche Unebenheiten können dazu führen, einen lokalen elektrischen Kurzschluss auszubilden, der entweder sofort, oder erst nach einigen hundert Stunden Betrieb auftritt. Das würde zu einem Totalausfall der Vorrichtung führen.

Die erste und/oder zweite Elektrode kann angrenzende Schichten aufweisen mit einer Schichtdicke, die größer ist als die Höhe der Unebenheiten. Beispielsweise können solche Schichtdicken mehr als 100 nm umfassen. Damit können die Unebenheiten in den Oberflächen der jeweiligen Elektrode eingeschlossen werden und somit verhindert werden, dass starke elektrische Feldüberhöhungen zu elektrischen Kurzschlüssen führen. Das Umhüllen der Unebenheiten durch Vergrößerung der Dicke der an die Elektroden angrenzenden Schichten kann aus elektrischer Sicht durchgeführt werden, wenn diese Schichten eine hohe Transparenz sowie eine hohe Leitfähigkeit aufweisen. Somit wird die optische Qualität der Vorrichtung durch die Vergrößerung der Schichtdicke nicht beeinflusst und keine elektrischen Verluste erlitten. Es ist weiterhin günstig, wenn die Unebenheiten eine gute Benetzbarkeit aufweisen, sodass die Umformung durch das Schichtmaterial der an die Elektroden angrenzenden Schichten die Unebenheiten gut überdeckt. Die an die erste Elektrode angrenzende Schicht kann die erste dotierte Transportschicht umfassen, und die an die zweite Elektrode angrenzende Schicht kann die zweite dotierte Transportschicht umfassen. Die erste dotierte Transportschicht kann beispielsweise eine Elektronentransportschicht und die zweite dotierte Transportschicht eine Lochtransportschicht umfassen.

Die erste dotierte Transportschicht weist einen Gradienten in ihrer Dotierung auf. Die zweite dotierte Transportschicht kann einen Gradienten in ihrer Dotierung aufweisen. Die erste dotierte Transportschicht ist in drei Teilschichten aufgeteilt, wobei die erste Teilschicht den zur ersten Elektrode am nächsten liegenden Bereich darstellt, die dritte Teilschicht den zur zweiten Elektrode am nächsten gelegenen Bereich darstellt und die zweite Teilschicht den Bereich zwischen der ersten und der dritten Teilschicht darstellt. Weiterhin kann die zweite dotierte Transportschicht in drei Teilschichten aufgeteilt sein, wobei die erste Teilschicht den zur ersten Elektrode am nächsten liegenden Bereich darstellt, die dritte Teilschicht den zur zweiten Elektrode am nächsten gelegenen Bereich darstellt und die zweite Teilschicht den Bereich zwischen der ersten und der dritten Teilschicht darstellt. Die Konzentration der Dotierung in der zweiten Teilschicht ist im Durchschnitt höher als in der ersten und dritten Teilschicht.

Die Konzentration in der ersten und dritten Teilschicht kann dann jeweils in Richtung zweite Teilschicht hin ansteigen oder abfallen. Die Gradienten in der Dotierung der Transportschichten können Staueffekte der Ladungsträger verhindern und Bandverbiegungen vermeiden. Weiterhin können durch die Gradienten Veränderungen der Emissionszonen vermieden und die Lebensdauer der Vorrichtung erhöht werden. Das erste Emittermaterial kann fluoreszent und das zweite Emittermaterial phosphoreszent sein. Weiterhin kann das erste Material fluoreszent und das zweite und dritte Emittermaterial phosphoreszent sein. Somit werden hoch effiziente phosphoreszente Emittermaterialien zusammen mit weniger effizienten fluoreszenten Emittermaterialien kombiniert, die gemeinsam mit den verwendeten Matrixmaterialien in den leitfähigkeitsdotierten Transportschichten und Blockierschichten eine effiziente Emission bei gleichzeitig hoher Lebensdauer ermöglichen.

Die strahlungsemittierende Vorrichtung kann eine organische Leuchtdiode (OLED) umfassen. Die OLED kann eine erste und zweite Emissionsschicht oder eine erste, zweite und dritte Emissionsschicht umfassen, die organische Materialien aufweisen. Von der OLED kann Licht emittiert werden, das durch die Mischung der Emission von Strahlung der ersten Emissionsschicht und der zweiten Emissionsschicht oder durch Mischung von Emission der Strahlung der ersten Emissionsschicht, der zweiten Emissionsschicht und der dritten Emissionsschicht erzeugt wird. Diese Mischung kann weißes Licht umfassen, wobei beispielsweise jeweils eine der Emissionsschichten rote Strahlung, blaue Strahlung oder grüne Strahlung emittiert.

Somit werden durch den Einsatz von ladungstransportierenden Schichten, die Ladungsträger der ersten und zweiten Ladung transportieren, mit optimierten Kombinationen von Emittermaterialien und Matrixmaterialien sowie angepassten Blockierschichten und dotierten Transportschichten in einer kavitativ optimierten Struktur gezielt Verlustkanäle ausgeschaltet und die Emissionen der einzelnen Emittermaterialien verbessert. Dies führt zu hoher Effizienz bei guter Lebensdauer und geringer Farbortvariation über einen weiten Helligkeitsbereich. Die Kombination von ambipolaren Matrixmaterialien, die in den Emissionsschichten und ladungstransportierenden Schichten vorhanden sind, mit kavitativ optimierten Schichtdicken, angepassten Ladungsträgerblockierschichten und leitfähigkeitsdotierten Ladungsträgertransportschichten dient zur gleichzeitigen Optimierung von Lebensdauer und Effizienz bei einstellbarer Emissionsfarbe. Dabei führen die ambipolaren Matrixmaterialien zu einer Unterdrückung von Polaronenquenching mit Exzitonen and den Grenzflächen, sowie zu einer Verhinderung von Energietransfers zwischen verschiedenen Emittermaterialien. Somit ist die Vorrichtung besonders geeignet für weiße OLEDs, die für Beleuchtungsanwendungen einsetzbar sind.

Es wird weiterhin ein Verfahren zur Herstellung einer strahlungsemittierenden Vorrichtung mit den oben genannten Eigenschaften angegeben. Das Verfahren weist die folgenden Verfahrensschritte auf:
A) Bereitstellen eines ersten Emittermaterials und eines zweiten Emittermaterials zur Herstellung einer ersten Emissionsschicht und einer zweiten Emissionsschicht,
   und
B) Erzeugen der ersten Emissionsschicht auf einer ersten Elektrode, der zweiten Emissionsschicht auf der ersten Emissionsschicht, und einer zweiten Elektrode auf der zweiten Emissionsschicht.

Weiterhin kann im Verfahrensschritt A) zusätzlich ein drittes Emittermaterial zur Herstellung einer dritten Emissionsschicht bereitgestellt werden und im Verfahrensschritt B) die dritte Emissionsschicht zwischen der zweiten Emissionsschicht und der zweiten Elektrode angeordnet werden.

In einem Verfahrensschritt A1) vor dem Verfahrensschritt A) kann das erste Emittermaterial mit einer Matrix, die Ladungsträger einer ersten Ladung und/oder Ladungsträger einer zweiten Ladung transportiert, vermischt werden und das zweite Emittermaterial mit einer Matrix, die Ladungsträger einer ersten Ladung und/oder einer zweiten Ladung transportiert, vermischt werden. In dem Verfahrensschritt A1) kann weiterhin das dritte Emittermaterial mit einer Matrix, die Ladungsträger einer ersten Ladung und/oder einer zweiten Ladung transportiert, vermischt werden. Dabei können beispielsweise die Ladungsträger der ersten Ladung Elektronen und die Ladungsträger der zweiten Ladung Löcher umfassen.

Die Matrix kann ein Matrixmaterial, das Ladungsträger der ersten und zweiten Ladung transportiert, aufweisen. Es kann weiterhin ein erstes Matrixmaterial, das Ladungsträger der ersten Ladung transportiert, und ein zweites Matrixmaterial, das Ladungsträger der zweiten Ladung transportiert, aufweisen.

In einem auf den Verfahrensschritt A) folgenden Verfahrensschritt B1) kann weiterhin ein erstes ladungstransportierendes Material, das Ladungsträger einer ersten Ladung und Ladungsträger einer zweiten Ladung transportiert, zur Herstellung einer ersten ladungstransportierenden Schicht bereitgestellt werden. Im Verfahrensschritt B1) kann weiterhin zusätzlich ein zweites ladungstransportierendes Material, das Ladungsträger einer ersten Ladung und Ladungsträger einer zweiten Ladung transportiert, zur Herstellung einer zweiten ladungstransportierenden Schicht bereitgestellt werden. Das erste und zweite ladungstransportierende Material kann eine Matrix umfassen, die ein Ladungsträger der ersten und zweiten Ladung transportierendes Matrixmaterial umfasst oder ein erstes Matrixmaterial, das Ladungsträger der ersten Ladung transportiert, und ein zweites Matrixmaterial, das Ladungsträger der zweiten Ladung transportiert.

Im Verfahrensschritt B) kann die erste ladungstransportierende Schicht zwischen der ersten Emissionsschicht und der zweiten Emissionsschicht angeordnet werden und/oder die zweite ladungstransportierende Schicht zwischen der zweiten und der dritten Emissionsschicht angeordnet werden.

Im Verfahrensschritt A) können weitere Schichten bereitgestellt werden, die aus einer Gruppe ausgewählt sind, die eine erste Blockierschicht, eine zweite Blockierschicht, eine erste dotierte Transportschicht und eine zweite dotierte Transportschicht umfassen. Weiterhin können im Verfahrensschritt B) die erste dotierte Transportschicht auf der ersten Elektrode angeordnet werden und die erste Blockierschicht auf der ersten dotierten Transportschicht und/oder die zweite Blockierschicht zwischen der der zweiten Elektrode an nächsten gelegenen Emissionsschicht und der zweiten Elektrode, und die zweite dotierte Transportschicht zwischen der zweiten Blockierschicht und der zweiten Elektrode.

Anhand der Ausführungsbeispiele und der Figuren soll die Erfindung näher erläutert werden:
- Figur 1: zeigt die schematische Seitenansicht einer Ausführungsform für eine Schichtenfolge der strahlungsemittierenden Vorrichtung.
- Figur 2: zeigt a) ein Emissionsspektrum einer strahlungsemittierenden Vorrichtung vor und nach der Alterung sowie b) die Lage der Emissionsfarbe im CIE-Diagramm von 1931.
- Figur 3: zeigt einen Energieschemaquerschnitt durch eine strahlungsemittierende Vorrichtung.
- Figur 4: zeigt Emissionsspektren von strahlungsemittierenden Vorrichtungen mit einem ersten und zweiten Matrixmaterial in einer Emissionsschicht.
- Figur 5: zeigt Emissionsspektren einer strahlungsemittierenden Vorrichtung ohne Ladungsträgertransportschicht und mit Ladungsträgertransportschicht.
- Figur 6: zeigt Emissionsspektren von strahlungsemittierenden Vorrichtungen ohne Ladungsträgertransportschicht und mit Ladungsträgertransportschicht (Figur 6a), wobei die Verhältnisse der Matrixmaterialien in der ladungstransportierenden Schicht variieren (Figur 6b) .
- Figur 7: zeigt das Emissionsspektrum einer strahlungsemittierenden Vorrichtung bei verschiedenen Leuchtdichten.
- Figur 8: zeigt Aufnahmen von strahlungsemittierenden Vorrichtungen bei verschiedenen Dicken (Figuren 8a und 8b) der zweiten dotieren Transportschicht.
- Figur 9: zeigt simulierte Spektren der Leuchtdichte bei verschiedenen Schichtdicken der Elektrode (Figuren 9a und 9b).

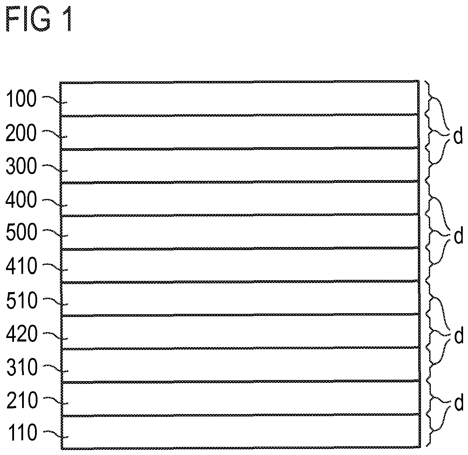

Anhand der Figur 1 soll eine beispielhafte Schichtenfolge für eine strahlungsemittierende Vorrichtung gezeigt werden. Die Vorrichtung umfasst eine erste Elektrode 100, eine erste dotierte Transportschicht 200, eine erste Blockierschicht 300, eine erste Emissionsschicht 400, eine erste ladungstransportierende Schicht 500, eine zweite Emissionsschicht 410, eine zweite ladungstransportierende Schicht 510, eine dritte Emissionsschicht 420, eine zweite Blockierschicht 310, eine zweite dotierte Transportschicht 210 und eine zweite Elektrode 110. Die Schichtdicken d der ersten Blockierschicht 300, der zweiten Blockierschicht 310 sowie der ersten ladungstransportierenden Schicht 500 betragen jeweils 5 bis 15 nm, vorzugsweise von 5 bis 10 nm, wobei die erste Blockierschicht 300 auch eine Dicke von 10 bis 400 nm betragen kann. Die Schichtdicken der zweiten ladungstransportierenden Schicht 510 betragen bis zu 15 nm, vorzugsweise bis zu 5 nm, der ersten und zweiten Emissionsschicht 400, 410 jeweils 5 bis 15 nm, der dritten Emissionsschicht 420 jeweils 5 bis 10 nm. Die erste und zweite dotierte Transportschicht 200, 210 weisen Schichtdicken von 5 bis 400 nm, vorzugsweise von 100 bis 400 nm auf. Die erste Elektrode 100 weist eine Dicke von 40 bis 200 nm, vorzugsweise von 100 bis 200 nm auf, die zweite Elektrode 110 eine Dicke von ca. 120 nm.

Im Folgenden wird von einer strahlungsemittierenden Vorrichtung ausgegangen, bei der die erste Elektrode 100 eine reflektierende Kathode, beispielsweise eine Ag-Schicht, und die zweite Elektrode 110 eine transparente Anode, beispielsweise eine ITO-Schicht (Indium-Zinn-Oxid) sind. Die erste Emissionsschicht 400 stellt eine fluoreszente blaue Emissionsschicht, die zweite Emissionsschicht 410 eine phosphoreszente grüne Emissionsschicht und die dritte Emissionsschicht 420 eine phosphoreszente rote Emissionsschicht dar. Natürlich können die Elektroden und Emissionsschichten auch jeweils untereinander ausgetauscht werden. Es wird weiterhin davon ausgegangen, dass die blaue Emissionsschicht ein fluoreszentes Emittermaterial in einer Elektronen leitenden Matrix, die phosphoreszente grüne Emissionsschicht Emittermaterialien in einer Loch und Elektronen leitenden Matrix und die phosphoreszente rote Emissionsschicht Emittermaterial in einer Loch transportierenden Matrix aufweisen. Auch diese Matrix-Zusammensetzungen in den einzelnen Emissionsschichten können beliebig variiert werden. Die beiden ladungstransportierenden Schichten 500, 510 weisen jeweils eine Matrix, die Loch- und Elektronen-leitend ist, auf, was ebenfalls variiert werden kann.

Es werden im Folgenden Beispiele für Materialien angegeben, die für die jeweiligen Schichten eingesetzt werden können. Die Aufzählung ist jedoch nicht vollständig, der Einsatz weiterer hier nicht genannter Materialien ist vorstellbar. Je nach gewünschter Effizienz, Emissionsfarbe und Lebensdauer können die Materialien der übrigen Schichten gewählt und variiert werden.

Die zweite Elektrode 110 ist in dem Ausführungsbeispiel eine transparente Anode, beispielsweise eine ITO-Anode (Indium-Zinn-Oxid-Anode). Die erste Elektrode 100 umfasst eine reflektive Kathode, beispielsweise aus Silber oder Aluminium.

Die zweite dotierte Transportschicht 210 kann p-dotiert sein und eine Lochtransportschicht umfassen. Beispiele für Materialien, die als Lochtransportmaterial eingesetzt werden können, sind 1-TNATA (4,4',4"-Tris(N-(naphth-1-yl)-N-phenylamino)triphenylamin), das in Formel 1 gezeigt ist:

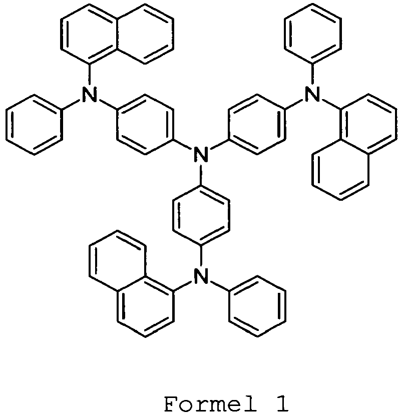

Ein weiteres Beispiel ist MTDATA (4,4',4"-Tris(N-3-metylphenyl-N-phenyl-amino)triphenylamin), wie in Formel 2 dargestellt:

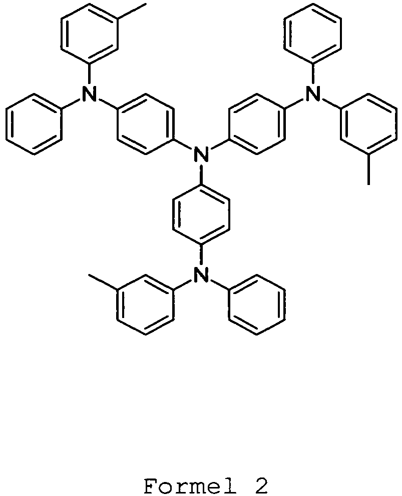

Weitere Beispiele sind 2-TNATA (4,4',4"-Tris(N-(naphth-2-yl)-N-phenyl-amino)triphenylamin), α-NPB (N,N'-Bis(napthalen-1-yl)-N,N'-bis(phenyl)benzidin), β-NPB (N,N'-Bis(naphthalen-2-yl)-N,N'-bis(phenyl)benzidin), TPD (N,N'-Bis(3-methylphenyl)-N,N'-bis(phenyl)benzidin), spTAD (2,2',7,7'-Diphenylamino-spiro-9,9'-bifluoren), Cu-PC (Phthalocyaninkupferkomplexe), weitere Phthalocyanin-MetallKomplexe, Pentacen und TAPC (1,1-Bis-[(4-phenyl-)-bis-(4', 4"-methyl-phenyl)-amino]-cyclohexan).

Diese Materialien weisen ein HOMO (Highest Occupied Molecular Orbital) von -5,2 ± 0,4 eV und ein LUMO (Lowest Unoccupied Molecular Orbital) von -2,2 ± 0,4 eV auf. Die Lochmobilität beträgt etwa 10⁻⁴ cm²/Vs und die Leitfähigkeit einer dotierten Schicht bei 2 bis 10 Vol% des Dotierstoffs beträgt etwa 10⁻⁵ S/cm.

Als Dotierstoff in einer Lochtransportschicht dient beispielsweise F₄-TCNQ (2,3,5,6-Tetrafluoro-7,7,8,8-tetracyanoquinodimethan), das in Formel 3 gezeigt ist:

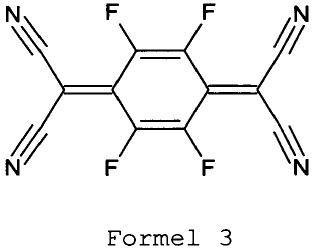

Weitere Dotierstoffe sind beispielsweise Molybdänoxid und Rheniumoxid.

Als zweite Blockierschicht 310, die als Elektronenblockierschicht dient, kann α-NPD (N,N'-Di-1-Naphthyl-N,N'-diphenyl-4,4'-diamino-biphenyl) eingesetzt werden, wie in Formel 4 gezeigt:

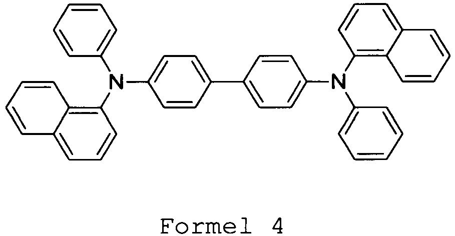

Dieses Material weist ein HOMO von -5 ± 0,4 eV und ein LUMO von mehr als -2,2 eV auf. Die Lochmobilität beträgt etwa 10⁻⁴ cm²/Vs.

Ist die dritte Emissionsschicht 420 eine rote, phosphoreszente Emissionsschicht, so dient als phosphorenzentes, rotes Emittermaterial Ir(DBQ)₂acac (Iridium(III)bis(2-methyldibenzo-[f,h]quinoxalin)(acetylacetonat)), wie in Formel 5 gezeigt:

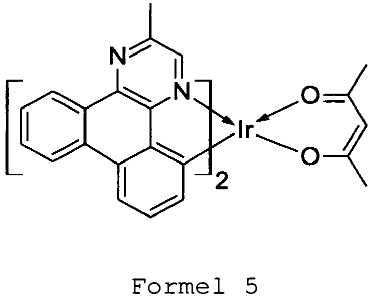

Dieses Emittermaterial hat eine Hauptemissionswellenlänge von über 600 nm, und im CIE-Diagramm von 1931 einen x-Wert von > 0,6 und einen y-Wert von < 0,36.

Eine rote Emissionsschicht kann eine Matrix aufweisen, die Löcher transportiert. Ein geeignetes Matrixmaterial ist α-NPD (N,N'-di-1-naphthyl-N,N'-diphenyl-4,4'-diamino-biphenyl), wie in Formel 4 gezeigt. Das Material weist ein HOMO von -5,5 ± 0,4 eV und ein LUMO von -2,1 ± 0,4 eV auf. Die Lochmobilität beträgt etwa 10⁻⁴ cm²/Vs und die Triplettlage T1 liegt bei über 1,8 eV.

Zwischen der dritten 420 und der zweiten Emissionsschicht 410 kann eine zweite ladungstransportierende Schicht 510 vorhanden sein, die ein erstes und zweites Matrixmaterial aufweist.

Das erste Matrixmaterial der zweiten ladungstransportierenden Schicht 510 kann ein Loch transportierendes Matrixmaterial umfassen, das beispielsweise 1-TNATA oder α-NPD sein kann. Diese Materialien haben ein HOMO von -5,5 ± 0,6 eV und ein LUMO von -2,1 ± 0,4 eV. Die Lochmobilität beträgt etwa 10⁻⁴ cm²/Vs und die Triplettlage T1 ist > 1,8 eV.

Ein Elektronen leitendes, zweites Matrixmaterial in der zweiten ladungstransportierenden Schicht 510 kann beispielsweise BCP (2,9-Dimethyl-4,7-diphenyl-1,10-phenanthrolin) sein, das in Formel 6 gezeigt ist:

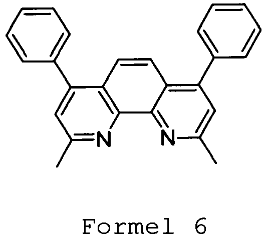

Ein weiteres Beispiel ist BPhen (4,7-diphenyl-1,10-phenantrolin), das in Formel 7 gezeigt ist:

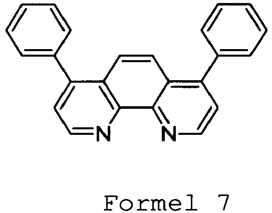

Diese Materialien haben die Eigenschaft, dass das HOMO -6,4 bis -5,7 eV und das LUMO -2,3 bis -1,8 eV beträgt, T1 > 2,5 eV ist, und die Elektronenmobilität etwa 10⁻⁶ cm²/Vs beträgt.

Die zweite Emissionsschicht 410 ist eine grüne phosphoreszente Emissionsschicht, die ein grünes Emittermaterial in einem ersten und zweiten Matrixmaterial aufweist. Als grünes Emittermaterial kann beispielsweise Irppy (fac-Tris(2-phenyl-pyridyl)-iridium) eingesetzt werden, das in Formel 8 gezeigt ist:

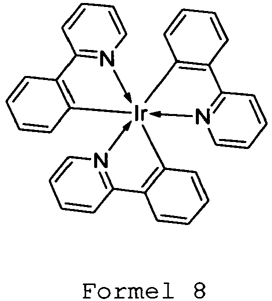

Das Material hat eine Hauptemissionswellenlänge bei 500 bis 570 nm und im CIE-Diagramm von 1931 einen x-Wert von etwa 0,37 und einen y-Wert von etwa 0,6.

Ein Loch transportierendes, erstes Matrixmaterial in der zweiten Emissionsschicht 410 kann beispielsweise TCTA (4,4',4"-Tris(carbazol-9-yl)triphenylamin) sein, das in Formel 9 gezeigt ist:

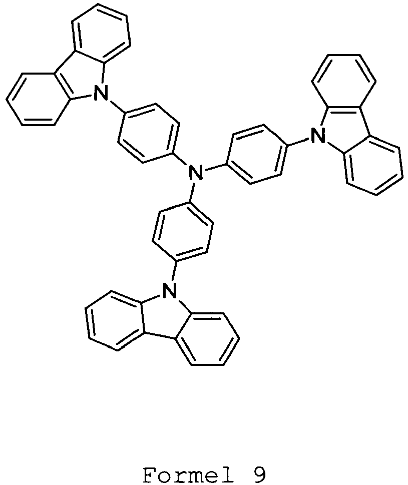

Oder es kann CBP (4,4'-Bis(carbazol-9-yl)biphenyl) sein, das in Formel 10 gezeigt ist:

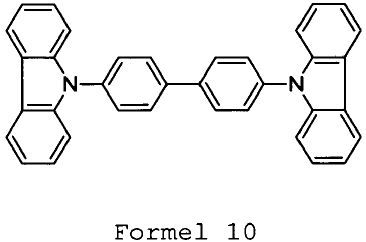

Diese Materialien haben ein HOMO von -6,0 bis - 5,3 eV und ein LUMO von -2,3 ± 0,1 eV, ein T1 von über 2,5 eV und eine Lochmobilität von etwa 10⁻⁴ cm²/Vs.

Ein Elektronen leitendes, zweites Matrixmaterial in der zweiten Emissionsschicht 410 ist beispielsweise BCP oder BPhen mit den bereits oben genannten Eigenschaften, wobei die Elektronenmobilität größer als 10⁻⁵ cm²/Vs, vorzugsweise 10⁻⁴ cm²/Vs sein sollte.

Zwischen der grünen, zweiten Emissionsschicht 410 und der ersten Emissionsschicht 400, die eine fluoreszente, blaue Emissionsschicht sein kann, befindet sich die erste ladungstransportierende Schicht 500, die sich aus einem ersten und einem zweiten Matrixmaterial zusammensetzt. Das erste Matrixmaterial kann ein Loch transportierendes Matrixmaterial sein, das TCTA oder CBP mit den oben genannten Eigenschaften sein kann. Das Elektronen leitende Matrixmaterial kann BCP oder BPhen mit den oben genannten Eigenschaften sein.

Die blaue, dritte Emissionsschicht 400 kann eine fluoreszente Emissionsschicht sein, mit dem blauen fluoreszenten Emittermaterial DPVBi (4,4'-Bis(2,2-diphenyl-ethen-1-yl)-diphenyl), wie in Formel 11 gezeigt:

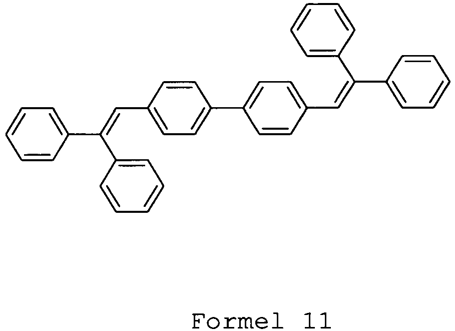

Dieses Material hat eine Hauptemissionswellenlänge bei 450 bis 770 nm, eine Halbwertsbreite von etwa 60 nm und im CIE-Diagramm von 1931 x-Werte von 0,14 bis 0,22 und y-Werte von 0,11 bis 0,20.

Das blaue Emittermaterial kann in einer Elektronen leitenden Matrix vorhanden sein, die als Material TBADN (2-tert-Butyl-9,10-di(2-naphhtyl)anthracen) umfassen kann, wie in Formel 12 gezeigt:

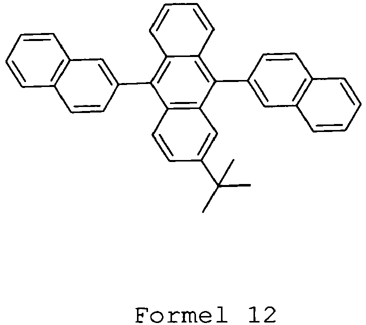

Dieses Material weist ein HOMO von -5,8 bis -5,3 eV und ein LUMO von -2,5 bis -1,8 eV auf. Die Bandlücke beträgt mehr als 3 eV und die Elektronenmobilität ist größer als 10⁻⁶ cm²/Vs, vorzugsweise größer als 10⁻⁵ cm²/Vs.

Als erste Blockierschicht 300 dient eine Lochblockierschicht, die als Material BCP oder BPhen mit den oben genannten Eigenschaften aufweist. Wichtig ist hier die Elektronenmobilität von mehr als 10⁻⁶ cm²/Vs, vorzugsweise mehr als 10⁻⁵ cm²/Vs, bei einer sehr geringen bis gar keinen Lochmobilität.

Die erste dotierte Transportschicht 200 kann eine n-dotierte Elektronentransportschicht sein, die als Elektronen leitendes Matrixmaterial BPhen (Formel 7), Alq₃ (Tris(8-Hydroxichinolin)aluminium), BAlq₂ (Bis-[2-methyl-8-quinolinato]-[4-phenylphenolato]-aluminium(III)), BCP (Formel 6), TPBi (1,3,5-Tris-(1-phenyl-1H-benzimidazol-2-yl)-benzen), TAZ (3-(4-Biphenyl)-4-phenyl-5-(4-tert-butylphenyl)-1,2,4-triazol), TAZ2 (3,5-Diphenyl-4-naphth-1-yl-1,2,4-triazol), t-Bu-PBD (2-(4-Biphenylyl)-5-(4-tert-butyl-phenyl)-1,3,4-oxadiazol), Triazin oder Triazinderivate aufweist. Das Matrixmaterial weist ein HOMO von -6,4 bis -6,0 eV, ein LUMO von -2,3 bis -1,8 eV, eine Elektronenmobilität von mehr als 10⁻⁶ cm²/Vs, vorzugsweise mehr als 10⁻⁵ cm²/Vs und eine Leitfähigkeit in einer dotierten Schicht (bei 6 bis 50 Vol% Dotierstoff) von 10⁻⁵ S/cm auf. Als Dotierstoff kann beispielsweise Lithium, Cäsium oder Calcium eingesetzt werden.

Für alle Schichten sind natürlich auch andere Matrixmaterialien, Dotierstoffe oder Emittermaterialien möglich, sowie andere Zusammensetzungen der gemischten Matrixmaterialien. Weitere Materialien für Emittermaterialien, Transportmaterialien und Dotierstoffe sind möglich und können jederzeit ausgetauscht werden.

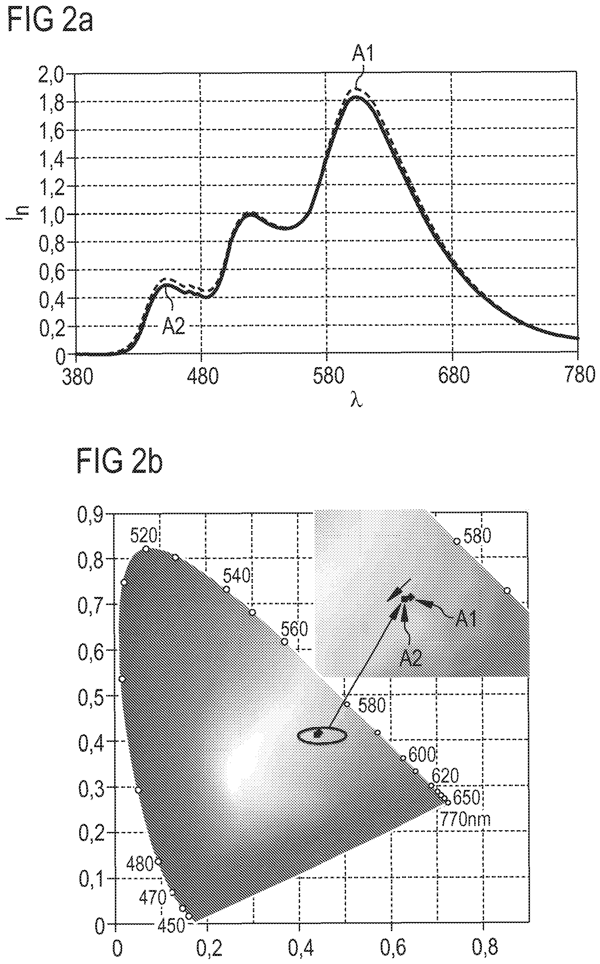

Figur 2a zeigt ein Emissionsspektrum einer strahlungsemittierenden Vorrichtung vor und nach der Alterung. Die Vorrichtung in diesem Beispiel umfasst drei direkt aufeinander folgende Emissionsschichten 400, 410 und 420, deren Emittermaterialien jeweils in einer leitenden Matrix vorliegen. Dabei weisen die zweite, grüne Emissionsschicht 410 und die dritte, rote Emissionsschicht 420 jeweils eine Mischung des ersten und zweiten Matrixmaterials, also eine Loch und Elektronen transportierende Matrix, auf. Die blaue, erste Emissionsschicht 400 weist eine vorwiegend Elektronen leitende Matrix auf. Die Alterung ist in diesem Fall so definiert, dass die Vorrichtung bei 1000 Cd/m² betrieben wurde, bis die halbe Leuchtdichte erreicht war. Vor und nach dem Betreiben der Vorrichtung wurden die Emissionsspektren A1 (vor der Alterung) und A2 (nach der Alterung) gemessen. In dem Emissionsspektrum, in dem die normalisierte Intensität In in willkürlichen Einheiten gegen die Wellenlänge λ in nm aufgetragen ist, ist zu sehen, dass die Vorrichtung eine Emissionsfarbe aufweist, die sich über die Lebensdauer hinweg nur wenig verändert, da die beiden Emissionsspektren fast deckungsgleich sind. Der gleiche Effekt ist in Figur 2b, in dem CIE-Diagramm von 1931 zu sehen, in dem die Emissionsfarben vor der Alterung A1 und nach der Alterung A2 kaum den Farbort gewechselt haben und somit sehr ähnliche x- und y-Werte aufweisen. Somit kann gezeigt werden, dass die in den Emissionsschichten vorhandene Loch und Elektronen leitende Matrix in der grünen und roten Emissionsschicht sowie die Elektronen leitende Matrix in der blauen Emissionsschicht auch nach einem Alterungsprozess kaum einen negativen Einfluss auf die Emissionsfarbe der Vorrichtung hat. Eine derart aufgebaute Vorrichtung ist also während ihrer Betriebsdauer farbstabil.

Es konnte gezeigt werden, dass auch Vorrichtungen, die ladungstransportierende Schichten zwischen der ersten und zweiten Emissionsschicht aufweisen, farbstabil sind. Solche Vorrichtungen weisen ladungstransportierende Schichten auf, die frei sind von Triarylaminen.

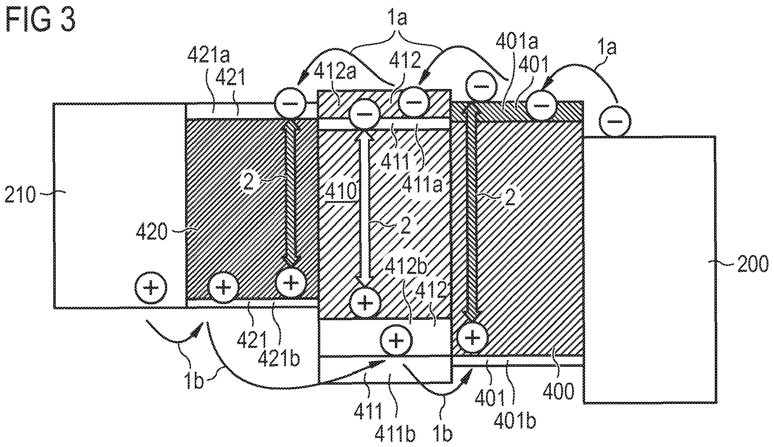

Figur 3 zeigt einen Energieschemaquerschnitt durch eine strahlungsemittierende Vorrichtung, die eine dritte Emissionsschicht 420, die rot emittiert und ein Loch leitendes Matrixmaterial 421 aufweist, eine erste Emissionsschicht 400, die blau emittiert und ein Elektronen leitendes Matrixmaterial 401 aufweist, und eine zweite Emissionsschicht 410, die grün emittiert und sowohl ein Loch leitendes Matrixmaterial 412 als auch ein Elektronen leitendes Matrixmaterial 411 aufweist, wobei die drei Emissionsschichten direkt aufeinander folgen. Die drei Emissionsschichten, deren jeweiliger energetische Abstand zwischen HOMO und LUMO 2 ebenfalls in Figur 3 schematisch als Doppelpfeile angedeutet ist, befinden sich zwischen zwei dotierten Transportschichten 200, 210, die zweite dotierte Transportschicht 210 ist eine Lochtransportschicht und die erste dotierte Transportschicht 200 ist eine Elektronentransportschicht. Die rote, dritte Emissionsschicht 420 weist ein rotes Emittermaterial auf und eine Loch leitendes Matrixmaterial 421, das ein HOMO 421a und ein LUMO 421b aufweist. Analog weist die erste Emissionsschicht 400, die blaue Emissionsschicht, ein Matrixmaterial auf, das Elektronen leitend ist, und ein HOMO 401a und ein LUMO 401b umfasst. Die grüne, zweite Emissionsschicht 410 weist ein Loch leitendes Matrixmaterial 412 auf, mit einem HOMO 412a und einem LUMO 412b und ein Elektronen leitendes Matrixmaterial mit einem HOMO 411a und einem LUMO 411b. Diese Abfolge der Emissionsfarben führt zu einer guten Radianz in Vorwärtsrichtung.

Das phosphoreszente rote Emittermaterial ist bevorzugt in ein Loch leitendes Matrixmaterial 421 eingebettet, sodass die Löcher von der Anode leicht zur mittleren grünen, zweiten Emissionsschicht 410 gelangen können und somit den anderen Emissionsschichten ebenfalls zur Verfügung stehen (Lochtransport 1b).

Die grüne, zweite Emissionsschicht 410 hat ein grünes Emittermaterial, das sowohl in ein Elektronen leitendes 411 als auch Loch leitendes Matrixmaterial 412 eingebettet ist. Dadurch ist nur eine geringe Konzentration an grünem Emittermaterial notwendig, sodass Quenching wie beispielsweise in Form der Triplett-Annihiliation verringert wird. Der Lochtransport 1b durch die grüne, zweite Emissionsschicht 410 zur blauen, ersten Emissionsschicht 400 ist gewährleistet. Beim Einsatz von zwei Matrixmaterialien ist darauf zu achten, dass die Lage von HOMO- und LUMO-Werten der beiden Matrixmaterialien aneinander angepasst sind. So sollte das LUMO des Elektronen leitenden Matrixmaterials tiefer als das LUMO des Loch leitenden Matrixmaterials und das HOMO des Elektronen leitenden Matrixmaterials tiefer als das HOMO des Loch leitenden Matrixmaterials liegen. Zu beachten sind außerdem die Triplettlagen T1 der eingesetzten Matrixmaterialien, welche für beide Matrixmaterialien energetisch höher liegen müssen, als die Triplettlage T1 des eingesetzten Emittermaterials. Anderenfalls kann ein Elektronentransfer auf das T1-Niveau des Matrixmaterials erfolgen mit anschließendem nicht strahlenden Zerfall des Exzitons.

Der Lochtransport 1b kann also in der Vorrichtung über das HOMO des zusätzlichen Loch leitenden Matrixmaterials 412 der grünen, zweiten Emissionsschicht 410 stattfinden, sodass es möglich ist, die Konzentration des grünen Emittermaterials auf Konzentrationen von 1 bis 10% zu reduzieren. Das grüne Emittermaterial in geringer Konzentration wirkt nun lediglich als Lochfalle, entfaltet somit seine maximale Quanteneffizienz und trägt nur sehr gering zum Lochtransport bei. Die Schichtdicke der grünen, zweiten Emissionsschicht 410 kann aufgrund der gesteigerten Effizienz verringert werden. Dies führt zu einer verringerten Betriebsspannung. Weiterhin führt der verbesserte Ladungsträgertransport zu einem verringerten Potenzialabfall über der grünen, zweiten Emissionsschicht 410. Durch das Mischungsverhältnis von bevorzugt Loch und Elektronen leitenden Matrixmaterialien 411, 412 lässt sich der Lochtransport 1b und Elektronentransport 1a in der Schichtenfolge regulieren und dadurch die Emissionsfarbe einstellen.

Erhöht man den Anteil des bevorzugt Loch leitenden Matrixmaterials 412, so verschiebt sich das Spektrum der Gesamtemission der Vorrichtung zugunsten des blauen Anteils. Umgekehrt verschiebt sich das Spektrum zugunsten von Rot und Grün, wenn man den Anteil des bevorzugt Elektronen leitenden Matrixmaterials 411 erhöht. Beispielsweise ist ein Verhältnis von 30% Loch leitendem Matrixmaterial 412, 60% Elektronen leitendem Matrixmaterial 411 und 10% grünem Emittermaterial für warmes Weiß geeignet (im CIE-Diagramm von 1931 0,4/0,4). Ein Verhältnis mit erhöhter Konzentration des Loch leitenden Matrixmaterials 412 wie z. B. 45% Loch leitendes Matrixmaterial 412, 45% Elektronen leitendes Matrixmaterial 411 und 10% grüner Emitter ist passend, um den blauen Anteil des Spektrums zu erhöhen und somit kühleres Weiß einzustellen (CIE: 0,33/0,33).

Durch den Einsatz eines Loch transportierenden Matrixmaterials 421 in der roten, dritten Emissionsschicht 420 stauen sich die injizierten Elektronen an der Grenzfläche zur grünen, zweiten Emissionsschicht 410 an. An dieser Grenzfläche bilden sich die überwiegende Anzahl der Exzitonen. Dadurch, dass die Dicke der roten, dritten Emissionsschicht 420 keinen Einfluss auf die Intensität der roten Emission aufweist, kann gezeigt werden, dass die Rekombination der Exzitonen fast ausschließlich an der Grenzfläche zur grünen, zweiten Emissionsschicht 410 erfolgt. Durch die hohe Konzentration an angeregten Zuständen (Exzitonen) an dieser Grenzfläche kommt es zu Auslöschungsprozessen, wie Triplett-Triplett-Annihilation und Exzitonen-Polaronen-Quenching.

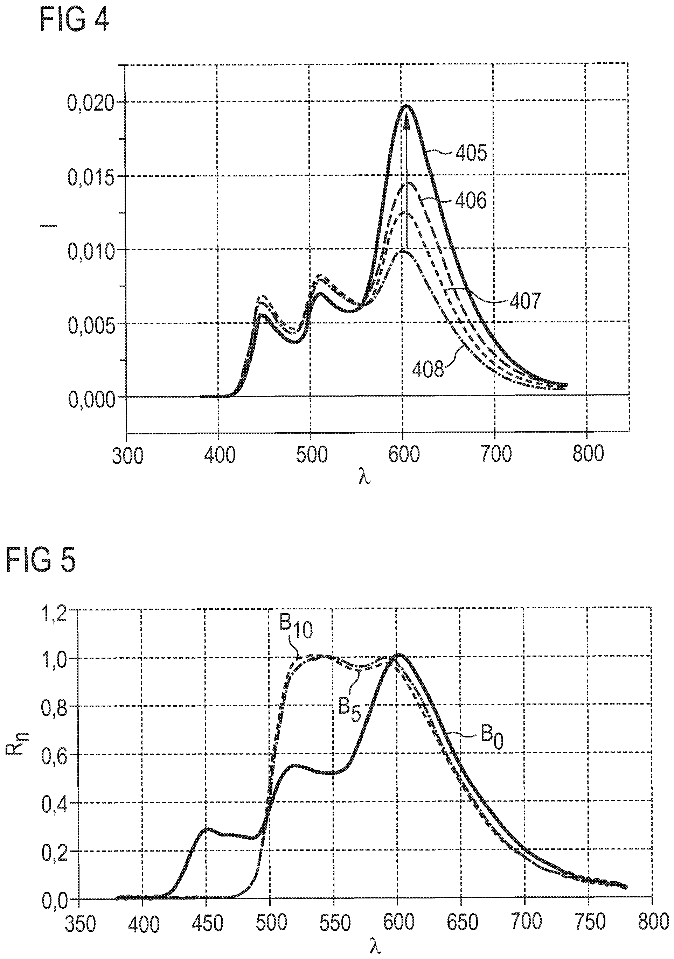

Um diese Verlustmechanismen zu vermeiden und somit die Kenndaten der Schichtenfolge zu verbessern, wurde in die rote, dritte Emissionsschicht 420 eine Mischung aus zwei Matrixmaterialien eingebracht. Durch das Einbringen einer Elektronen leitenden Matrix in die rote Emissionsschicht kann die Rekombinationszone verbreitert werden. Dabei werden die anderen Farben nicht negativ beeinflusst, sondern lediglich die rote Emission intensiviert. Damit wird die Gesamteffizienz der Vorrichtung erhöht. Das ist beispielsweise in Figur 4 zu sehen. Hier sind Emissionsspektren von strahlungsemittierenden Vorrichtungen gezeigt mit einer gemischten Matrix aus zwei Matrixmaterialien in der roten, dritten Emissionsschicht 420.

Es wird die Intensität I gegen die Wellenlänge λ in nm aufgetragen. Es wurde die Emission von vier Vorrichtungen gemessen, wobei die roten Emissionsschichten jeweils verschiedene Mischungsverhältnisse der Matrixmaterialien aufweisen. Das Spektrum 405 zeigt die Emission einer Vorrichtung mit einem Mischungsverhältnis der Matrixmaterialien in der roten Emissionsschicht von 45% Loch leitendem Matrixmaterial und 45% Elektronen leitendem Matrixmaterial. Das Spektrum 406 zeigt die Emission mit einem Mischungsverhältnis von 55% Loch leitendem Matrixmaterial und 35% Elektronen leitendem Matrixmaterial in der roten Emissionsschicht. Die Spektren 407 und 408 zeigen die Emissionen von Vorrichtungen mit Mischungsverhältnissen in der roten Emissionsschicht von 65% Loch leitendem Matrixmaterial zu 25% Elektronen leitendem Matrixmaterial (Spektrum 407) bzw. 75% Loch leitendes Matrixmaterial und 15% Elektronen leitendes Matrixmaterial (Spektrum 408). Es ist zu sehen, dass mit erhöhtem Anteil Elektronen leitenden Matrixmaterials die Emission im roten Bereich (bei ca. 600 nm) erhöht wird, während die Emissionen im grünen (bei ca. 520 nm) und blauen (bei ca. 450 nm) Bereich fast konstant bleiben. Somit kann gezeigt werden, dass durch Variation des Mischungsverhältnisses der Matrixmaterialien die Intensität der roten Emission variiert werden kann, ohne die anderen Farben negativ zu beeinflussen.

Liegt eine strahlungsemittierende Vorrichtung vor, bei der zwischen der blauen, ersten Emissionsschicht 400 und grünen, zweiten Emissionsschicht 410 keine ladungstransportierende Schicht vorhanden ist, grenzt die grüne phosphoreszente Emissionsschicht direkt an die fluoreszierende blaue Emissionsschicht an. Sollte die Triplett-Energie des fluoreszent blauen Emittermaterials oder des Matrixmaterials für den blauen Emitter unterhalb der Triplett-Energie des grünen phosphoreszenten Emittermaterials liegen, so wird ein Exzitonentransfer mittels Förster-Transfer von Grün nach Blau stattfinden. Da beim fluoreszierenden blauen Emittermaterial oder des Matrixmaterials hierfür nur die Singulett-Exzitonen strahlend zerfallen, gehen somit die Triplett-Exzitonen, die von Grün auf Blau transferiert wurden, verloren, da sie nicht strahlend rekombinieren. Um in einem solchen Fall diesen Transfer zu unterbinden, kann eine Zwischenschicht, die eine erste ladungstransportierende Schicht 500 ist, mit einer bestimmten Dicke zwischen der grünen phosphoreszenten Emissionsschicht und der fluoreszierenden blauen Emissionsschicht eingefügt werden. Die Triplett-Energie dieser ladungstransportierenden Schicht sollte dabei stets höher liegen als die Triplett-Energie des grünen phosphoreszenten Emitters. Durch Einbau einer ladungstransportierenden Schicht mit nur einem Typ von Matrixmaterial verhindert man diesen Transfer, verändert aber das Ladungsträgergleichgewicht der Schichtenfolge vollständig. Fügt man beispielsweise eine Elektronen leitende ladungstransportierenden Schicht ein, so erhält man eine vorwiegend rote und grüne Emission, da mehr Löcher in der grünen, zweiten Emissionsschicht 410 aufgestaut werden und somit weniger Löcher in die blaue, erste Emissionsschicht 400 gelangen.

Dies ist beispielsweise in Figur 5 gezeigt, wo Emissionsspektren einer Vorrichtung ohne ladungstransportierende Schicht B₀ und Emissionsspektren von Vorrichtungen mit einer ladungstransportierenden Schicht zwischen der blauen und grünen Emissionsschicht von 5 nm Dicke B₅ und 10 nm Dicke B₁₀ gezeigt sind. Dabei ist die normalisierte Radianz Rₙ in W/(srm²nm) gegen die Wellenlänge λ in nm aufgetragen. Die Vorrichtung ohne ladungstransportierende Schicht zeigt eine weiße Emission mit Peak Maxima bei einer blauen Emission (ca. 450 nm), einer grünen Emission (ca. 520 nm) und einer roten Emission (ca. 600 nm). Die Spektren B₅ und B₁₀ zeigen eine Emission, bei der nur noch rote und grüne Strahlung vorhanden ist, die blaue Emission ist verschwunden. Dabei ist es unabhängig, wie dick diese ladungstransportierende Schicht zwischen blauer und grüner Emissionsschicht ist, da die Spektren B₅ und B₁₀ eine sehr ähnliche Verteilung aufweisen. Generell sollte eine ladungstransportierende Schicht zwischen der blauen und der grünen Emissionsschicht jedoch mindestens eine Dicke von 5 nm aufweisen. Würde man eine rein Loch leitende ladungstransportierende Schicht zwischen der blauen und grünen Emissionsschicht einfügen, so würde man eine vorwiegend blaue Emission erhalten, da mehr Elektronen in der blauen Emissionsschicht aufgestaut werden und somit weniger Elektronen in die rote und grüne Emissionsschicht gelangen (hier nicht gezeigt).

Um eine Verbesserung der Emission in der Schichtenfolge zu erreichen und weder den Loch- noch den Elektronentransport zu beeinträchtigen, kann eine erste ladungstransportierende Schicht 500 zwischen der grünen, phosphoreszenten, zweiten Emissionsschicht und der blauen, fluoreszenten, ersten Emissionsschicht eingefügt werden, die eine Mischung von Matrixmaterialien aufweist. Diese ladungstransportierende Schicht besteht aus einem Loch leitenden Matrixmaterial und einem Elektronen leitenden Matrixmaterial. Hierbei sollte wiederum das LUMO des Elektronen leitenden Matrixmaterials tiefer als das LUMO des Loch leitenden Matrixmaterials und das HOMO des Elektronen leitenden Matrixmaterials tiefer als das HOMO des Loch leitenden Matrixmaterials liegen. Diese ladungstransportierende Schicht kann nun beide Ladungsträgertypen transportieren, aber der Transfer von grünen Triplett-Exzitonen auf die blaue Emissionsschicht wird verhindert. Damit wird die Gesamteffizienz der Vorrichtung erhöht. Die optimale Dicke dieser ladungstransportierenden Schicht ist dabei entscheidend. Bei zu geringer Dicke wird der Transfer nicht ausreichend unterbunden und bei zu hoher Dicke fällt darüber zu viel Spannung ab. Durch das Mischungsverhältnis von Loch und Elektronen leitendem Matrixmaterial lässt sich der Loch- und Elektronentransport in der Vorrichtung regulieren und dadurch die Farbe der Gesamtemission einstellen. Eine geeignete Materialkombination weist T1-Niveaus auf, die über dem T1-Niveau des grünen Emittermaterials liegen, sodass ein Abfließen von Triplett-Exzitonen auf die erste ladungstransportierende Schicht 500 unterbunden wird. Erhöht man den Anteil der Loch leitenden Matrix, so verschiebt sich das Spektrum zugunsten des blauen Anteils. Umgekehrt verschiebt sich das Spektrum zugunsten von Rot und Grün, wenn man den Anteil des Elektronen leitenden Matrixmaterials erhöht.

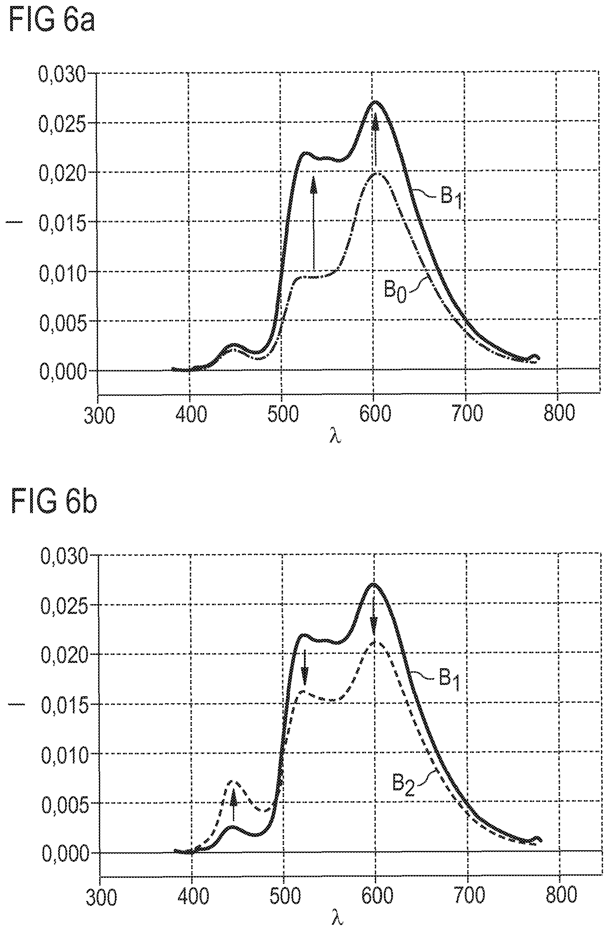

In den Figuren 6a und 6b sind zwei Emissionsspektren (Intensität I gegen Wellenlänge λ in nm) gezeigt. Die Spektren wurden von Vorrichtungen gemessen, die ladungstransportierende Schichten zwischen der fluoreszenten blauen Emissionsschicht und der phosphoreszenten grünen Emissionsschicht aufweisen, wobei die ladungstransportierenden Schichten unterschiedliche Mischungsverhältnisse der Matrixmaterialien enthalten. Das Spektrum B₀ in Figur 6a zeigt eine Vorrichtung ohne ladungstransportierende Schicht 500 zwischen der blauen, ersten Emissionsschicht 400 und der grünen, zweiten Emissionsschicht 410, das Spektrum B₁ zeigt eine Vorrichtung mit einer ladungstransportierenden Schicht 500 zwischen den beiden Emissionsschichten mit einem Verhältnis der beiden Matrixmaterialien von 50/50. Man sieht, dass der Einbau der ladungstransportierenden Schicht zu einer Erhöhung des Maximums in dem Emissionsspektrum B₁ besonders im roten und grünen Bereich (Peaks zwischen 500 und 700 nm) führt, während im blauen Bereich (bei etwa 450 nm) kein Unterschied des Spektrums B₁ zum Spektrum B₀ der Vorrichtung ohne ladungstransportierende Schicht zu sehen ist.

Das Emissionsspektrum B₂ in Figur 6b zeigt die Emission einer Vorrichtung mit einer ladungstransportierenden Schicht, in der das Verhältnis von Loch transportierendem Matrixmaterial zu Elektronen transportierendem Matrixmaterial 70/30 beträgt. Im Vergleich zu der Emission der Vorrichtung B₁ zeigt sich, dass hier nun der Peak im blauen Bereich (bei ca. 450 nm) erhöht ist, während die rote und grüne Emission (der Bereich bei 500 bis 700 nm) an Intensität verliert. Damit kann gezeigt werden, dass es durch die Variation der Mischungsverhältnisse der Matrixmaterialien in der ladungstransportierenden Schicht möglich ist, die Farbe der Gesamtemission gezielt einzustellen.

Eine weitere Verbesserung kann durch die Einführung einer zweiten ladungstransportierenden Schicht 510 mit zwei Matrixmaterialien zwischen der grünen, zweiten Emissionsschicht 410 und der roten, dritten Emissionsschicht 420 erreicht werden. Hierdurch wird der Transfer von Exzitonen vom grünen auf den roten Emitter unterbunden. Die Emissionseffizienz des grünen Emitters steigt, gleichzeitig sinkt die Intensität der roten Emission leicht, was gut durch den Einsatz einer gemischten Matrix in der roten Emissionsschicht kompensiert werden kann. Der ambipolare Charakter des Ladungstransportmaterials sorgt erneut für einen gleichmäßigen Ladungsträgertransport beider Ladungsträgertypen durch alle Schichten. Die Gesamteffizienz der Vorrichtung steigt, da höherenergetische grüne Exzitonen nicht unter Abgabe von Energie (in Form von Wärme) in niedrigenergetische rote Exzitonen transferiert werden. Die Gesamteffizienz des Bauteils kann durch eine derartige zweite ladungstransportierenden Schicht 510 um 20% gegenüber einer Vorrichtung ohne diese ladungstransportierende Schicht gesteigert werden, der Anteil der grünen Emission steigt um 40%, während die rote Emission um 10% sinkt. Ein weiterer Vorteil der zweiten ladungstransportierenden Schicht 510 mit zwei Matrixmaterialien besteht in der Möglichkeit, die Radianz in Vorwärtsrichtung für die einzelnen Emissionsschichten unabhängig voneinander und ohne die Emissionsfarbe an der Vorrichtung stark zu beeinflussen zu optimieren, da durch die Schichtdicken der ladungstransportierenden Schichten 500, 510 die Abstände der Emissionsschichten 400, 410 und 420 zu der reflektierenden ersten Elektrode 100 eingestellt werden kann.

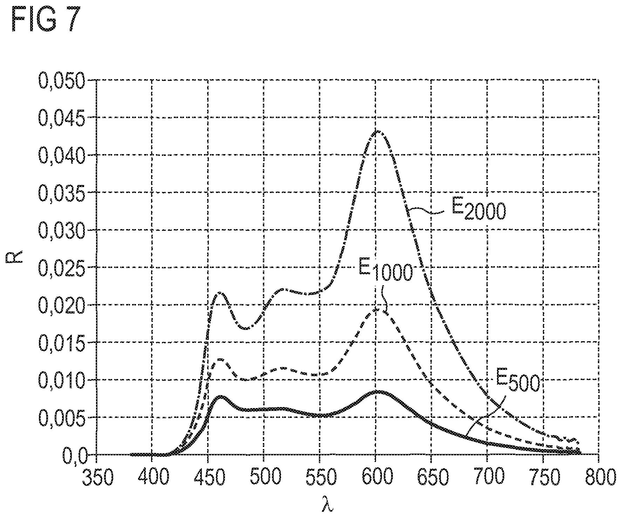

Abbildung 7 zeigt das Emissionsspektrum (Auftragung der Radianz R in W/srm²nm gegen die Wellenlänge λ in nm) einer Vorrichtung, mit einer ersten ladungstransportierenden Schicht 500 mit zwei Matrixmaterialien zwischen der grünen, zweiten Emissionsschicht 410 und der blauen, ersten Emissionsschicht 400 und einer grünen Emissionsschicht, die ebenfalls zwei Matrixmaterialien aufweist. Diese Vorrichtung wurde bei verschiedenen Leuchtdichten betrieben, die Spektren sind demnach als E₂₀₀₀ (bei 2000 Cd/m² betrieben), E₁₀₀₀ (bei 1000 Cd/m² betrieben) und E₅₀₀ (bei 500 Cd/m² betrieben) bezeichnet. Man sieht, dass durch eine Erhöhung der Leuchtdichte eine Farbverschiebung in Richtung Rot stattfindet (erhöhtes Peakmaximum bei ca. 600 nm), was jedoch nur zu einer Veränderung der Farbtemperatur führt, der Farbeindruck der Gesamtemission bleibt weiß.

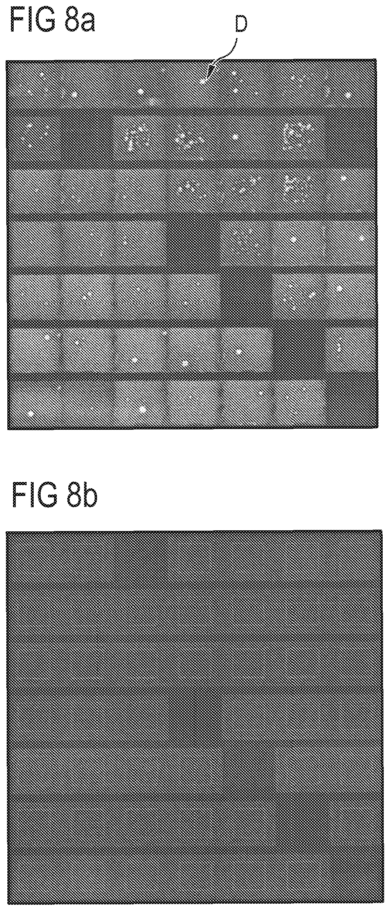

Figur 8 zeigt Aufnahmen einer Vorrichtung, bei der in Sperrrichtung eine Spannung von 4 V angelegt wurde. In Figur 8a ist eine Vorrichtung mit einer dotierten Transportschicht 210, in dem Fall eine Lochtransportschicht, zu sehen, deren Dicke 20 nm beträgt, in Figur 8b beträgt die Dicke der Lochtransportschicht 400 nm. Die weißen Flecken in der linken Abbildung zeigen, dass beim Anlegen der Spannung Kurzschlüsse D auftreten, sodass die Funktion der Vorrichtung ausgeschaltet ist. Bei einer Erhöhung der Schichtdicke, wie sie in der Figur 8b zu sehen ist, werden etwaige Unebenheiten auf der Anode, die unter der Lochtransportschicht liegt, überformt, sodass die Funktion der strahlungsemittierenden Vorrichtung erhalten bleibt.

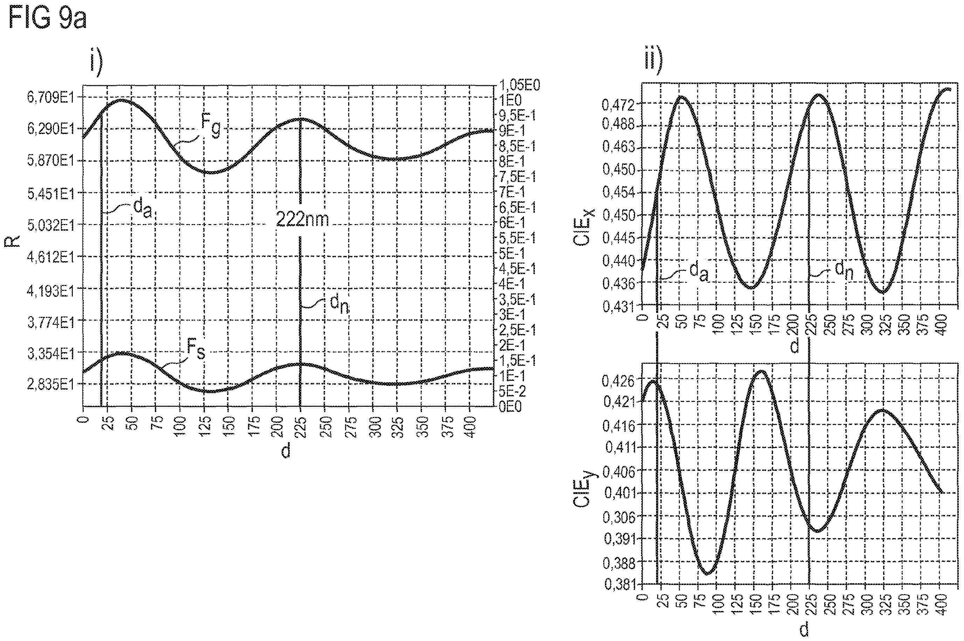

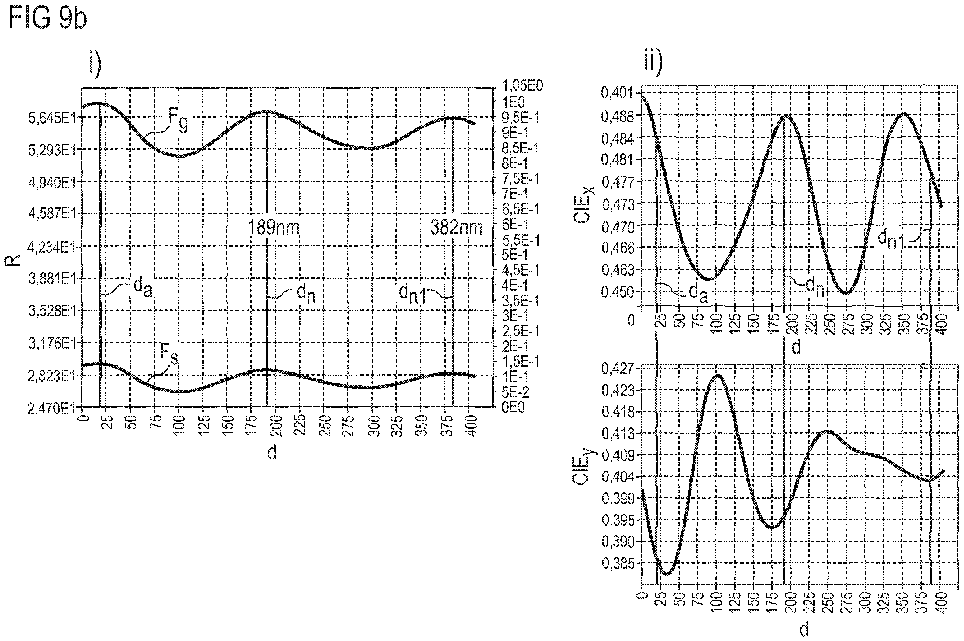

Die Figuren 9a und 9b zeigen Simulationsdaten zu der Radianz und den Emissionsfarben der Vorrichtung in Abhängigkeit der Schichtdicke der dotierten Transportschicht. In diesem Ausführungsbeispiel wird die Schichtdicke der Lochtransportschicht variiert. Die Figur 9a bezieht sich auf eine Vorrichtung mit einer 115 nm dicken ITO-Anode auf der die Lochtransportschicht angeordnet ist, die Figur 9b bezieht sich auf eine Vorrichtung mit einer 160 nm dicken ITO-Anode, auf der die Lochtransportschicht angeordnet ist. In den Spektren i) ist jeweils die Radianz R in W/(srm²nm) gegen die Schichtdicke d in nm aufgetragen. Die simulierte Radianz F_{g} setzt sich aus den parallelen und senkrechten elektrischen Feldern zusammen, was der Gesamtemission entspricht. Die gleiche Aussage hat die simulierte Radianz Fₛ, die nur eine Richtung, den s-polarisierten Anteil des elektrischen Feldes umfasst. In den Spektren ii) sind die x- und y-Werte des CIE-Diagramms von 1931, CIEₓ und CIE_{y}, gegen die Schichtdicke d in nm aufgetragen. In beiden Spektren i) und ii) sind jeweils eine Referenzschichtdicke dₐ von 20 nm sowie optimierte Schichtdicken dₙ und dₙ₁ eingezeichnet.

In Figur 9a ist eine Simulation gezeigt, bei der eine optimierte Schichtdicke dₙ von 222 nm berechnet wurde. Bei dieser Schichtdicke liegt ein Maximum in der simulierten Radianz Fₛ bzw. F_{g} vor, während die Quanteneffizienz durch die größere Schichtdicke nur um 5% sinkt. Gleichzeitig verschieben sich die CIEₓ und CIE_{y} Werte durch die Veränderung der Schichtdicke nur um +0.02 bzw. -0.03. Somit kann die Schichtdicke der Lochtransportschicht erhöht werden, um die Unebenheiten auf der Elektrode zu umformen, ohne dass die Effizienz oder der Farbort der strahlungsemittierenden Vorrichtung wesentlich verändert werden.

In Figur 9b sind analog zur Figur 9a zwei optimierte Schichtdicken dₙ und dₙ₁ von 189 bzw. 382 nm bei maximaler simulierter Radianz Fₛ bzw. F_{g} angegeben. Die Quanteneffizienz verringert sich um 1% bei einer Veränderung der Schichtdicke von 20 nm auf 189 nm und um 3% bei einer Veränderung der Schichtdicke von 20 nm auf 384 nm. Der CIEₓ Wert verändert sich gleichzeitig um + 0.003 bzw. 0.01 und der CIE_{y} Wert um -0.03 bzw. + 0.02.

Die in den Figuren 9a und 9b gezeigten Simulationen zeigen ebenfalls, dass die Gesamtdicke aus Elektrode und Transportschicht für die Quanteneffizienz und den Farbort der Gesamtemission eine Rolle spielt.

Die in den Figuren und Ausführungsbeispielen gezeigten Ausführungsformen können beliebig variiert werden. Es ist weiterhin zu berücksichtigen, dass sich die Erfindung nicht auf diese Beispiele beschränkt, sondern weitere, hier nicht aufgeführte Ausgestaltungen zulässt.

## Patentansprüche

1. Strahlungsemittierende Vorrichtung, umfassend
- eine erste Elektrode (100), die im Betrieb Ladungsträger einer ersten Ladung abgibt,
- eine erste dotierte Transportschicht (200), die die Ladungsträger der ersten Ladung transportiert und einen Gradienten in ihrer Dotierung aufweist, wobei die erste dotierte Transportschicht (200) in drei Teilschichten aufgeteilt ist und die Konzentration der Dotierung in der zweiten Teilschicht im Durchschnitt höher ist als in der ersten und dritten Teilschicht, wobei die zweite Teilschicht den Bereich zwischen der ersten und der dritten Teilschicht darstellt und wobei die erste dotierte Transportschicht (200) auf der ersten Elektrode (100) angeordnet ist,
- eine erste Emissionsschicht (400), die ein erstes Emittermaterial aufweist und auf der ersten dotierten Transportschicht (200) angeordnet ist,
- eine zweite Emissionsschicht (410), die ein zweites Emittermaterial aufweist und auf der ersten Emissionsschicht (400) angeordnet ist und
- eine zweite Elektrode (110), die im Betrieb Ladungsträger einer zweiten Ladung abgibt und auf der zweiten Emissionsschicht (410) angeordnet ist, **dadurch gekennzeichnet, dass**
- das erste und/oder zweite Emittermaterial phosphoreszent ist und das erste Emittermaterial Strahlung bei einer anderen Wellenlänge emittiert als das zweite Emittermaterial,
- zwischen der ersten Emissionsschicht (400) und der zweiten Emissionsschicht (410) eine erste ladungstransportierende Schicht (500) angeordnet ist, und
- die erste ladungstransportierende Schicht (500) eine Matrix umfasst, die ein Ladungsträger der ersten und zweiten Ladung transportierendes Matrixmaterial umfasst oder eine Mischung eines ersten, Ladungsträger der ersten Ladung transportierenden Matrixmaterials und eines zweiten, Ladungsträger der zweiten Ladung transportierenden Matrixmaterials vorhanden ist.

2. Vorrichtung nach dem vorhergehenden Anspruch, wobei eine dritte Emissionsschicht (420), die ein drittes Emittermaterial aufweist und zwischen der zweiten Emissionsschicht (410) und der zweiten Elektrode (110) angeordnet ist, vorhanden ist, wobei das dritte Emittermaterial bei einer anderen Wellenlänge Strahlung emittiert als das erste und zweite Emittermaterial.

3. Vorrichtung nach dem vorhergehenden Anspruch, wobei die dritte Emissionsschicht (420) Ladungsträger der zweiten Ladung transportiert.

4. Vorrichtung nach einem der Ansprüche 2 oder 3, wobei eine zweite ladungstransportierende Schicht (510), die zwischen der zweiten (410) und dritten Emissionsschicht (420) angeordnet ist, vorhanden ist.

5. Vorrichtung nach dem vorhergehenden Anspruch, wobei die zweite ladungstransportierende Schicht (510) eine Matrix umfasst, die ein Ladungsträger der ersten und zweiten Ladung transportierendes Matrixmaterial oder ein erstes, Ladungsträger der ersten Ladung transportierendes Matrixmaterial und ein zweites, Ladungsträger der zweiten Ladung transportierendes Matrixmaterial aufweist.

6. Vorrichtung nach einem der Ansprüche 2 bis 5, wobei die erste (400) und/oder zweite (410) und/oder dritte Emissionsschicht (420) eine Matrix umfasst, die ein Ladungsträger der ersten und zweiten Ladung transportierendes Matrixmaterial oder ein erstes, Ladungsträger der ersten Ladung transportierendes Matrixmaterial und ein zweites, Ladungsträger der zweiten Ladung transportierendes Matrixmaterial aufweist.

7. Vorrichtung nach einem der vorhergehenden Ansprüche, wobei die erste Elektrode (100) reflektierend für die vom ersten und/oder zweiten Emittermaterial emittierte Strahlung ist.

8. Vorrichtung nach Anspruch 2, wobei die erste Elektrode (100) reflektierend für die vom ersten und/oder zweiten Emittermaterial und/oder dritten Emittermaterial emittierte Strahlung ist.

9. Vorrichtung nach einem der Ansprüche 7 oder 8, wobei mit zunehmendem Abstand der Emissionsschichten (400, 410, 420) zur reflektierenden Elektrode die jeweiligen Emittermaterialien Strahlung bei größeren Wellenlängen emittieren.

10. Vorrichtung nach einem der vorhergehenden Ansprüche, wobei die zweite Elektrode (110) transparent für die vom ersten und/oder zweiten Emittermaterial emittierte Strahlung ist.

11. Vorrichtung nach Anspruch 2, wobei die zweite Elektrode (110) transparent für die vom ersten und/oder zweiten Emittermaterial und/oder dritten Emittermaterial emittierte Strahlung ist.

12. Vorrichtung nach einem der vorhergehenden Ansprüche, wobei die den Emissionsschichten (400, 410, 420) zugewandten Oberflächen der ersten (100) und/oder zweiten Elektrode (110) Unebenheiten einer bestimmten Höhe aufweisen.

13. Vorrichtung nach dem vorhergehenden Anspruch, wobei die an die erste (100) und/oder zweite Elektrode (110) angrenzende Schicht eine Schichtdicke aufweist, die größer ist als die Höhe der Unebenheiten.

## Claims

1. Radiation-emitting device, comprising
- a first electrode (100), which emits charge carriers of a first charge during operation,
- a first doped transport layer (200), which transports the charge carriers of the first charge and comprises a doping gradient, wherein the first doped transport layer (200) is subdivided into three sublayers and the concentration of the dopant is on average higher in the second sublayer than in the first and third sublayer, wherein the second sublayers represents the region between the first and the third sublayer, and wherein the first doped transport layer (200) is arranged on the first electrode (100),
- a first emission layer (400), which has a first emitter material and is arranged on the first doped transport layer (200),
- a second emission layer (410), which has a second emitter material and is arranged on the first emission layer (400) and
- a second electrode (110), which emits charge carriers of a second charge during operation and is arranged on the second emission layer (410), **characterized in that**
- the first and/or second emitter material is phosphorescent and the first emitter material emits radiation at a different wavelength from the second emitter material,
- a first charge-transporting layer (500) is arranged between the first emission layer (400) and the second emission layer (410), and
- the first charge-transporting layer (500) comprises a matrix, which has a matrix material transporting charge carriers of the first and second charge or a mixture of a first matrix material transporting charge carriers of the first charge and a second matrix material transporting charge carriers of the second charge.

2. Device according to the preceding claim, wherein a third emission layer (420) is present, which has a third emitter material and is arranged between the second emission layer (410) and the second electrode (110), wherein the third emitter material emits radiation at a different wavelength as the first and second emitter materials.

3. Device according to the preceding claim, wherein the third emission layer (420) transports charge carriers of the second charge.

4. Device according to one of claims 2 or 3, wherein a second charge-transporting layer (510) is present, which is arranged between the second (410) and third emission layer (420).

5. Device according to the preceding claim, wherein the second charge-transporting layer (510) comprises a matrix, which has a matrix material transporting charge carriers of the first and second charge or a mixture of a first matrix material transporting charge carriers of the first charge and a second matrix material transporting charge carriers of the second charge.

6. Device according to any one of claims 2 to 5, wherein the first (400) and/or second (410) and/or third emission layer (420) comprises a matrix, which has a matrix material transporting charge carriers of the first and second charge or a first matrix material transporting charge carriers of the first charge and a second matrix material transporting charge carriers of the second charge.

7. Device according to any one of the preceding claims, wherein the first electrode (100) is reflective to the radiation emitted by the first and/or second emitter material.

8. Device according to claim 2, wherein the first electrode (100) is reflective to the radiation emitted by the first and/or second emitter material and/or third emitter material.

9. Device according to one of claims 7 or 8, wherein with increasing distance of the emission layers (400, 410, 420) to the reflective electrode, the respective emitter materials emit radiation of a greater wavelength.

10. Device according to any one of the preceding claims, wherein the second electrode (110) is transparent for the radiation emitted by the first and/or second emitter material.

11. Device according to claim 2, wherein the second electrode (110) is transparent for the radiation emitted by the first and/or second emitter material and/or third emitter material.

12. Device according to any one of the preceding claims, wherein the surfaces of the first (100) and/or second electrode (110) facing the emission layers (400, 410, 420) have an unevenness of a specific height.

13. Device according to the preceding claim, wherein the layer adjoining the first (100) and/or second electrode (110) has a layer thickness which is greater than the height of the unevenness.

## Revendications

1. Dispositif émetteur de rayonnement, comportant
- une première électrode (100), qui en fonctionnement, émet des porteurs de charge d'une première charge,
- une première couche de transport dotée (200), qui transporte les porteurs de charge de la première charge et présente un gradient dans sa dotation, la première couche de transport dotée (200) étant répartie en trois couches partielles et la concentration de la dotation étant plus élevée en moyenne dans la seconde couche partielle que dans les première et troisième couches partielles, la seconde couche partielle représentant la zone entre la première et la troisième couche partielle, et la première couche de transport dotée (200) étant disposée sur la première électrode (100),
- une première couche d'émission (400), qui présente une première matière émettrice et est disposée sur la première couche de transport dotée (200),
- une seconde couche d'émission (410), qui présente une seconde matière émettrice et est disposée sur la première couche d'émission (400), et
- une seconde électrode (110), qui en fonctionnement, émet des porteurs de charge d'une seconde charge et est disposée sur la seconde couche d'émission (410), **caractérisée en ce que**
- la première et/ou la seconde matière émettrice est phosphorescente et la première matière émettrice émet du rayonnement à une autre longueur d'ondes que la seconde matière émettrice,
- entre la première couche d'émission (400) et la seconde couche d'émission (410) est disposée une première couche transportant de la charge (500), et
- la première couche transportant de la charge (500) comporte une matrice, qui comporte une matière de matrice transportant des porteurs de charge des première et seconde charges, ou un mélange étant présent d'une première matière de matrice transportant des porteurs de charge de la première charge et d'une seconde matière de matrice transportant des porteurs de charge de la seconde charge.

2. Dispositif selon la revendication précédente, une troisième couche d'émission (420) étant présente, qui présente une troisième matière émettrice et est disposée entre la seconde couche d'émission (410) et la seconde électrode (110) étant présente, la troisième matière émettrice émettant du rayonnement à une autre longueur d'ondes que la première et la seconde matières émettrices.

3. Dispositif selon la revendication précédente, la troisième couche d'émission (420) transportant les transporteurs de charge de la seconde charge.

4. Dispositif selon une quelconque des revendications 2 ou 3, une seconde couche (510) transportant de la charge étant présente, qui est disposée entre la seconde (410) et la troisième couche d'émission (420).

5. Dispositif selon la revendication précédente, la seconde couche transportant de la charge (510) comportant une matrice, qui présente une matière de matrice transportant des porteurs de charge de la première et de la seconde charges ou une première matière de matrice transportant des porteurs de charge de la première charge et une seconde matière de matrice transportant des porteurs de charge de la seconde charge.

6. Dispositif selon une quelconque des revendications 2 à 5, la première (400) et/ou seconde (410) et/ou troisième couche d'émission (420) comportant une matrice, qui présente une matière de matrice transportant des porteurs de charge de la première et de la seconde charges ou une première matière de matrice transportant des porteurs de charge de la première charge et une seconde matière de matrice transportant des porteurs de charge de la seconde charge.

7. Dispositif selon une quelconque des revendications précédentes, la première électrode (100) étant réfléchissante pour le rayonnement émis par la première et/ou seconde matière émettrice.

8. Dispositif selon la revendication 2, la première électrode (100) étant réfléchissante pour le rayonnement émis par la première et/ou seconde matière émettrice et/ou troisième matière émettrice.

9. Dispositif selon une quelconque des revendications 7 ou 8, les matières émettrices respectives émettant, avec un écart croissant des couches d'émissions (400, 410, 420) vers l'électrode réfléchissante, du rayonnement à de plus grandes longueurs d'ondes.

10. Dispositif selon une quelconque des revendications précédentes, la seconde électrode (110) étant transparente pour le rayonnement émis par la première et/ou seconde matière émettrice.

11. Dispositif selon la revendication 2, la seconde électrode (110) étant transparente pour le rayonnement émis par la première et/ou seconde matière émettrice et/ou troisième matière émettrice.

12. Dispositif selon une quelconque des revendications précédentes, les surfaces tournées vers les couches d'émission (400, 410, 420) de la première (100) et/ou de la seconde électrode (110) présentant des aspérités d'une certaine hauteur.

13. Dispositif selon la revendication précédente, la couche adjacente à la première (100) et/ou à la seconde électrode (110) présentant une épaisseur de couche qui est plus grande que la hauteur des aspérités.
